# EUROPÄISCHE PATENTSCHRIFT

(11) **EP 3 467 982 B1**
(45) Veröffentlichungstag und Bekanntmachung des Hinweises auf die Patenterteilung: **14.04.2021**
(21) Anmeldenummer: 18198550.8
(22) Anmeldetag: 04.10.2018
(51) Int. Cl.: H02H 3/093, H02H 3/08, H02H 3/00, H01H 71/74, H01H 85/46, H01H 85/00, G05F 1/66

(54) **ENERGIEVERSORGUNGSVORRICHTUNG**
POWER SUPPLY DEVICE
DISPOSITIF D'ALIMENTATION ÉLECTRIQUE

(30) Priorität: 09.10.2017 DE 102017123404
(43) Veröffentlichungstag der Anmeldung: 10.04.2019
(73) Patentinhaber: Phoenix Contact GmbH & Co. KG, 32825 Blomberg (DE)
(72) Erfinder: SCHMIDT, Olaf, 59494 Soest-Muellingsen (DE); ALSDORF, Lars, 59494 Soest (DE); HENKEL, Hartmut, 32825 Blomberg (DE)
(74) Vertreter: Patentship Patentanwaltsgesellschaft mbH

(56) Entgegenhaltungen:
- AT-A4- 506 092
- DE-A1- 3 902 416
- DE-A1-102008 064 393
- US-A1- 2009 109 590
- US-A1- 2010 214 709
- US-A1- 2014 268 459
- US-B1- 9 667 060

## Beschreibung

Die Offenbarung betrifft eine Energieversorgungsvorrichtung zur überstromgesicherten Versorgung eines elektrischen Verbrauchers mit elektrischer Leistung sowie ein entsprechendes Verfahren.

In einer Energieversorgungsvorrichtung kann eine Stromversorgungseinrichtung mit einem Leistungsschutzschalter kombiniert sein, welcher beispielsweise bei Erreichen eines Stromstärkegrenzwertes durch einen von der Stromversorgungseinrichtung zu dem elektrischen Verbraucher fließenden elektrischen Strom, den Transport von elektrischer Energie von der Stromversorgungseinrichtung zu dem elektrischen Verbraucher unterbindet oder begrenzt.

Der Leistungsschutzschalter ist üblicherweise statisch auf einen vorbestimmten Stromstärkegrenzwert oder Leistungsgrenzwert festgelegt. Der vorbestimmte Stromstärkegrenzwert oder Leistungsgrenzwert entspricht typischerweise einer dauerhaft, insbesondere dauerhaft zerstörungsfrei von dem elektrischen Verbraucher annehmbaren elektrischen Stromstärke respektive elektrischen Leistung. Allerdings kann der elektrische Verbraucher während eines Zeitintervalls den vorbestimmten Stromstärkegrenzwert oder Leistungsgrenzwert funktionsgemäß überschreiten. Nachteiliger Weise kann dieses Überschreiten den Leistungsschutzschalter auslösen und die Versorgung des elektrischen Verbrauchers mit elektrischer Energie durch die Stromversorgungseinrichtung unterbrechen oder begrenzen, sodass die Funktionsweise des elektrischen Verbrauchers eingeschränkt sein kann.

Die Druckschrift DE 39 02 416 A1 offenbart einen überstromsensitiven Selbstschalter zum Schutz elektrischer Komponenten. Der Selbstschalter umfasst ein mit einem Schaltschloss in Eingriff befindliches Schaltwerk zur Betätigung einer Kontaktanordnung sowie ein überstromsensitives Auslöseteil, welches mit dem Schaltschloss in Wirkverbindung steht und bei Überschreiten des jeweiligen Nennstromes dessen Abschaltung herbeiführt. Das Auslöseteil weist Mittel zur Erfassung und zur vorgebbaren Begrenzung der Größe und Dauer von Überströmen jeder Art auf. Insbesondere kann das Auswerteglied ein einstellbarer Operationsverstärker sein, der ein Zeitglied aufweist, welches die Dauer eines anstehenden Überstromes auswertet. Das Zeitglied ist ausgebildet, die Dauer eines von dem Sensorglied über eine doppelte Verbindungsleitung übermittelten Signals zu erfassen und mit einem vorgegebenen Grenzwert zu vergleichen. Die Druckschrift AT 506 092 A4 offenbart eine elektrische Anlage mit einem Verbraucher, welcher mittels einer Schutzeinrichtung abgesichert ist, wobei ein Auslöseparameter, insbesondere ein Auslösestrom, der Schutzeinrichtung einstellbar ist. Die elektrische Anlage weist eine Steuereinheit auf, welcher ein Strommesswert des von dem Verbraucher aufgenommenen Stromes zugeführt ist. Die Steuereinheit generiert in Abhängigkeit des Verlaufs des Strommesswertes einen Grenzwert, welcher der Schutzeinrichtung zur Einstellung eines Auslöseparameters vorgegeben ist. Die als Mikrocontroller ausgebildete Steuereinheit kann über einen Analog-Digital-Wandler den Messwert einer Strommesseinrichtung empfangen. Im Falle einer Überschreitung des aktuellen Auslöseparameters wird vom Mikrocontroller ein Auslösesignal über einen Signalverstärker an das Schaltelement der Schutzeinrichtung übertragen. Bei Verwendung eines mechanischen Schaltelements erfolgt eine Trennung des schadhaften Verbrauchers von der Speisespannung.

Die Druckschrift US 2014 / 268459 A1 offenbart eine Vorrichtung zum dynamischen Einstellen einer Überstromschutzschwelle. Eine dynamische Überstromschutzschaltung empfängt ein erstes Auslösesignal zum Umschalten in einen Modus mit hohem Entladestrom. Die dynamische Überstromschutzschaltung startet einen Hochstromzeitgeber und erhöht den Überstromschutzschwellenwert als Reaktion auf den Empfang des Auslösesignals. Die dynamische Überstromschutzschaltung verringert den Überstromschutzschwellenwert und startet einen Haltezeitgeber als Reaktion auf ein Ablaufen des Hochstromzeitgebers. Der Haltezeitgeber verhindert, dass ein zweites Auslösesignal ein Umschalten in den Modus mit hohem Entladestrom bewirkt, bis der Haltezeitgeber abläuft. Ein Triggergenerator kann mit einem dynamischen Überstromschwellengenerator gekoppelt sein, der ausgebildet ist, den dynamischen Überstromschwellengenerator zu veranlassen, die dynamische Überstromschutzschwelle zu erhöhen, die dem Überstromkomparator zugeführt wird. Der Triggergenerator kann einen Abtaststromwert erfassen, der die Überstromschutzschwelle überschreitet.

Die Druckschrift US 2010 / 214709 A1, offenbart ein Überstromschutzsteuersystem mit einer Motorsteuervorrichtung, die mit einer elektrischen Last gekoppelt ist und einem Mikroprozessor, der mit der Motorsteuervorrichtung gekoppelt und ausgebildet ist, ein Statussignal zu empfangen, das einen Betriebszustand der elektrischen Last angibt. Der Mikroprozessor ist ferner ausgebildet, einen Schwellenstromwert gemäß dem Betriebszustand der elektrischen Last einzustellen. Weiterhin umfasst das

Überstromschutzsteuersystem einen Stromsensor, der zwischen einer Stromquelle und der Motorsteuervorrichtung gekoppelt und ausgebildet ist, eine an die Motorsteuervorrichtung gelieferte Strommenge zu erfassen. Der Stromsensor ist ferner ausgebildet, ein Signal an den Mikroprozessor zu übertragen, welches die erfasste Strommenge angibt. Ferner umfasst das Überstromschutzsteuersystem ein Schaltelement, das zwischen die Stromquelle und die Motorsteuervorrichtung gekoppelt und ausgebildet ist, ein Signal von dem Mikroprozessor zu empfangen und entweder die Stromquelle elektrisch von der Motorsteuervorrichtung zu isolieren oder die Stromquelle elektrisch mit der Motorsteuervorrichtung zu koppeln. Der Mikroprozessor ist ferner ausgebildet, die erfasste Strommenge und den Schwellenstromwert zu vergleichen und ein Signal an das Schaltelement zu übertragen, um zu bewirken, dass das Schaltelement die Stromquelle von der Motorsteuervorrichtung elektrisch isoliert, wenn der erfasste Strombetrag größer ist als der Schwellenstromwert.

Die Druckschrift DE 10 2008 064393 B4 offenbart eine Vorrichtung zum Absichern einer elektrischen Leitung in einem Fahrzeug, umfassend eine elektrische Sicherung und ein steuerbares Schaltelement. Das steuerbare Schaltelement und die elektrische Sicherung sind als Parallelschaltung ausgebildet und die Parallelschaltung ist in Reihe mit der elektrischen Leitung verbindbar. Die elektrische Sicherung ist in einem ersten Zweig der Parallelschaltung angeordnet, der einen ersten Widerstand aufweist und das steuerbare Schaltelement ist in einem zweiten Zweig der Parallelschaltung angeordnet. Ferner ist das steuerbare Schaltelement ausgebildet mindestens zwei Zustände anzunehmen, einen ersten Zustand mit einem zweiten Widerstand höher als der erste Widerstand und einen zweiten Zustand mit einem dritten Widerstand niedriger als der erste Widerstand. Weiterhin ist das steuerbare Schaltelement ausgebildet, bei einer Impulslastbedingung in den zweiten Zustand zu schalten, wobei die Impulslastbedingung eine Überschreitung eines ersten Schwellenwerts des durch die Parallelschaltung fließenden Stromes darstellt.

Die Druckschrift US 2009 / 109590 A1 offenbart eine selbstgeschützte Festkörperschaltvorrichtung mit einer ersten Öffnungseinrichtung, die in Reihe mit einem ersten Sicherungseinsatz geschaltet ist, einer Einrichtung zum Messen des elektrischen Stroms und einer Steuereinrichtung, die auf das Öffnen und Schließen der ersten Öffnungseinrichtung gemäß dem Wert eines durch die Schalteinrichtung fließenden elektrischen Hauptstroms einwirkt. Die Vorrichtung umfasst mindestens einen zweiten Sicherungseinsatz, der parallel zu dem ersten Sicherungseinsatz geschaltet ist, wobei mindestens ein zweites elektrisches Öffnungsmittel in Reihe geschaltet ist.

Die Druckschrift US 9 667 060 B1 offenbart ein Energieüberwachungssystem, mit einer Stromerfassungsvorrichtung, welche ausgebildet ist, einen Laststromamplitudenwert einer elektrischen Last zu überwachen, die an einen Leistungseingang angeschlossen ist, und eine Änderungsrate des Laststromamplitudenwerts zu bestimmen. Ferner umfasst das Energieüberwachungssystem eine Datenverarbeitungsvorrichtung, welche ausgebildet ist, festzustellen, ob die Änderungsrate des Laststromamplitudenwertes einen vordefinierten Ratenschwellenwert überschreitet und als Reaktion auf ein Feststellen, dass die Änderungsrate des Laststromamplitudenwertes den vordefinierten Ratenschwellenwert überschreitet, einen Überstromschutzwert von einem ersten Überstromschutzwert auf einen angepassten Überstromschutzwert für eine erste vorbestimmte Zeitdauer zu ändern.

Es ist die Aufgabe des Gegenstands der vorliegenden Offenbarung eine verbesserte Energieversorgungsvorrichtung zur effizienteren Bereitstellung elektrischer Energie für einen elektrischen Verbraucher bereitzustellen. Diese Aufgabe wird durch die Merkmale der unabhängigen Ansprüche 1 und 11 gelöst. Vorteilhafte Ausführungsformen der Offenbarung sind Gegenstand der abhängigen Ansprüche, der Beschreibung sowie der beigefügten Zeichnungen.

Die Offenbarung basiert auf der Erkenntnis, dass die obige Aufgabe durch eine Energieversorgungsvorrichtung gelöst werden kann, welche eine Stromversorgungseinrichtung mit einem Leistungsschutzschalter kombiniert, welcher einen variablen Stromstärkegrenzwert aufweist. Der Leistungsschutzschalter kann einen von der Stromversorgungseinrichtung zu dem elektrischen Verbraucher fließenden elektrischen Strom begrenzen oder den Stromfluss unterbinden, falls der Stromstärkegrenzwert überschritten wird. Der Stromstärkegrenzwert kann für eine begrenzte Zeit angehoben werden, um während dieser Zeit einen Stromfluss mit einer höheren Stromstärke zuzulassen ohne die Stromstärke zu begrenzen oder den Stromfluss zu unterbinden.

Gemäß einem ersten Aspekt betrifft die Offenbarung eine Energieversorgungsvorrichtung zur überstromgesicherten Versorgung eines elektrischen Verbrauchers mit elektrischer Leistung. Die Energieversorgungsvorrichtung umfasst eine Stromversorgungseinrichtung, welche ausgebildet ist, einen elektrischen Strom für den elektrischen Verbraucher bereitzustellen, und ein steuerbares Leistungsschutzelement, welches ausgebildet ist, die Zufuhr des elektrischen Stromes zu dem elektrischen Verbraucher bei Erreichen eines ersten Stromstärkegrenzwertes durch den elektrischen Strom zu unterbinden. Das steuerbare Leistungsschutzelement weist ferner einen durch die Stromversorgungseinrichtung einstellbaren zweiten Stromstärkegrenzwert auf, wobei der zweite Stromstärkegrenzwert höher als der erste Stromstärkegrenzwert ist. Die Stromversorgungseinrichtung ist ferner ausgebildet, einen erhöhten Leistungsbedarf des elektrischen Verbrauchers in einem Zeitintervall zu erfassen, und ansprechend auf das Erfassen des erhöhten Leistungsbedarfs das steuerbare Leistungsschutzelement bis zum Ablauf des Zeitintervalls zur Einstellung des zweiten Stromstärkegrenzwertes anzusteuern, wobei das steuerbare Leistungsschutzelement ausgebildet ist, bei eingestelltem zweiten Stromstärkegrenzwert die Zufuhr des elektrischen Stromes zu dem elektrischen Verbraucher bei Erreichen des zweiten Stromstärkegrenzwertes durch den elektrischen Strom zu unterbinden.

Die Stromversorgungseinrichtung kann eine elektrische Energiequelle, insbesondere ein Schaltnetzteil aufweisen, welche über einen Versorgungsnetzanschluss mit einem externen Energieversorgungsnetz oder einem internen Energiespeicher verbunden sein kann. Hierzu kann die Stromversorgungseinrichtung Anschlüsse für elektrische Leitungen, insbesondere in Form von Steck-, Schraub-, oder Klemmverbindern aufweisen. Weiterhin kann die elektrische Verbindung zu dem elektrischen Verbraucher lösbar mittels einer Steck-, Schraub-, oder Klemmverbindung realisiert sein.

Die Energieversorgungsvorrichtung kann ausgebildet sein, dauerhaft mit einem Strom mit einer Stromstärke unterhalb des ersten Stromstärkegrenzwertes betrieben zu werden, wobei neben dem ersten Stromstärkegrenzwert weitere Parameter den Leistungstransport von der Stromversorgungseinrichtung zu dem elektrischen Verbraucher bestimmen können. Beispielsweise können zulässige Bereiche für eine Stromfrequenz, eine Stromphase und/oder eine elektrische Spannung des elektrischen Stroms definiert sein.

Das Begrenzen oder Unterbinden des Stromflusses von der Stromversorgungseinrichtung über eine Stromversorgungsleitung zu dem elektrischen Verbraucher mittels des steuerbaren Leistungsschutzelements kann durch Erreichen eines einzelnen Grenzwertes der zuvor genannten Grenzwerte oder eine Kombination von Grenzwerten der zuvor genannten Grenzwerte realisiert sein. Beispielsweise kann mittels einer Kombination des Spannungsgrenzwertes mit dem Stromstärkegrenzwert ein Begrenzen oder Unterbinden des Stromflusses bei Erreichen einer vorbestimmten elektrischen Leistung realisiert sein.

Die Energieversorgungsvorrichtung kann ausgebildet sein, zeitlich begrenzt mit dem zweiten Stromstärkegrenzwert betrieben zu werden, wobei der zweite Stromstärkegrenzwert durch die Art des elektrischen Verbrauchers bestimmt sein kann. Mit dem zweiten Stromstärkegrenzwert kann insbesondere ein Boost-Modus für die Versorgung des elektrischen Verbrauchers mit einem Überstrom realisiert sein, wobei der Überstrom eine über den ersten Stromstärkegrenzwert erhöhte Stromstärke aufweisen kann.

Dieser Überstrom kann genutzt werden, um eine Sicherung des elektrischen Verbrauchers definiert und/oder schnell auszulösen, um ein Fließen eines elektrischen Stroms mit einer Stromstärke oberhalb des zweiten Stromstärkegrenzwertes zu unterbinden. Ferner kann durch ein Zulassen des Fließens des Überstroms ein Einbrechen der elektrischen Spannung an dem elektrischen Verbraucher verhindert werden, sodass Sicherungsgeräte, insbesondere magnetisch aktivierte Sicherungsgeräte zuverlässig auslösen können.

Wurde durch das steuerbare Leistungsschutzelement zu einem zurückliegenden Zeitpunkt der zweite Stromstärkegrenzwert eingestellt und ist zum aktuellen Zeitpunkt der erste Stromstärkegrenzwert eingestellt, kann die Stromversorgungseinrichtung ausgebildet sein, ein Einstellen des zweiten Stromstärkegrenzwertes zu unterbinden. Dadurch kann vorteilhafter Weise verhindert werden, dass das steuerbare Leistungsschutzelement dauerhaft den zweiten Stromstärkegrenzwert einstellt.

In einer Ausführungsform ist die Stromversorgungseinrichtung ausgebildet, das steuerbare Leistungsschutzelement nach Ablauf des Zeitintervalls zur Einstellung des ersten Stromstärkegrenzwertes anzusteuern, und das steuerbare Leistungsschutzelement ist ausgebildet, bei eingestelltem ersten Stromstärkegrenzwert die Zufuhr des elektrischen Stromes zu dem elektrischen Verbraucher bei Erreichen des ersten Stromstärkegrenzwertes durch den elektrischen Strom zu unterbinden.

Der elektrische Verbraucher kann ausgebildet sein, zeitbegrenzt einen elektrischen Strom mit einer Stromstärke oberhalb des ersten Stromstärkegrenzwertes zu benötigen und somit eine elektrische Leistung oberhalb der mit dem ersten Stromstärkegrenzwert realisierbaren elektrischen Leistung von der Energieversorgungsvorrichtung zu fordern. Vorteilhafterweise kann das Zeitintervall in welchem das steuerbare Leistungsschutzelement den zweiten Stromstärkegrenzwert einstellt, begrenzt sein, um die Energieversorgungsvorrichtung und/oder den elektrischen Verbraucher vor einer Überlastung zu schützen.

Nach Ablauf des insbesondere vorbestimmten und/oder begrenzten Zeitintervalls kann das steuerbare Leistungsschutzelement den ersten Stromstärkegrenzwert einstellen, sodass der über die Stromversorgungsleitung fließende elektrische Strom auf den ersten Stromstärkegrenzwert beschränkt sein kann. Die Stromstärke kann unterhalb des zweiten Stromstärkegrenzwertes und oberhalb des ersten Stromstärkegrenzwertes liegen, sodass bei einem Einstellungswechsel von dem ersten Stromstärkegrenzwert zu dem zweiten Stromstärkegrenzwert das steuerbare Leistungsschutzelement auslösen kann, um einen Stromfluss zu dem elektrischen Verbraucher zu unterbinden oder in der Stromstärke zu begrenzen.

In einer Ausführungsform ist die Stromversorgungseinrichtung ausgebildet, bei Erfassen einer Stromstärke des elektrischen Versorgungsstroms, welche unterhalb des ersten Stromstärkegrenzwertes liegt das steuerbare Leistungsschutzelement zur Einstellung des ersten Stromstärkegrenzwertes anzusteuern. Dadurch wird der Vorteil erreicht, dass die Stromversorgungseinrichtung zwischen dem ersten Stromstärkegrenzwert und dem zweiten Stromstärkegrenzwert des steuerbaren Leistungsschutzelements umschalten kann Die Stromversorgungseinrichtung kann ausgebildet sein, einen Wechsel von dem zweiten Stromstärkegrenzwert zu dem ersten Stromstärkegrenzwert nach Ablauf des Zeitintervalls, bei Unterschreiten des ersten Stromstärkegrenzwertes, bei einer Benutzereingabe, bei einem Zurücksetzen der Energieversorgungsvorrichtung und/oder bei einem Neustart der Energieversorgungsvorrichtung durchzuführen.

Erfindungsgemäß ist die Stromversorgungseinrichtung ausgebildet, den höheren Leistungsbedarf bei einer steigenden Stromamplitude des elektrischen Stroms zu detektieren. Dadurch wird der Vorteil erreicht, dass bereits vor einem Überschreiten des ersten Stromstärkegrenzwertes der zweite Stromstärkegrenzwert eingestellt werden kann. Die steigende Stromamplitude kann beispielsweise über eine zeitliche Differenz der Stromamplitude erfasst werden.

Erfindungsgemäß ist die Stromversorgungseinrichtung weiter ausgebildet, den erhöhten Leistungsbedarf bei einer steigenden Stromamplitude des elektrischen Stroms zu detektieren, falls eine Amplitudensteigung einen vorbestimmten Steigungsgrenzwert nicht überschreitet. Dadurch wird der Vorteil erreicht, dass ein Wechsel des Stromstärkegrenzwertes auch bei langsam oder nicht messbar ansteigenden Stromstärken erfolgen kann.

In einer Ausführungsform weist das steuerbare Leistungsschutzelement einen Strompfad auf, welcher durch den elektrischen Strom durchsetzbar ist, und das steuerbare Leistungsschutzelement ist ausgebildet, den ersten Stromstärkegrenzwert oder den zweiten Stromstärkegrenzwert in dem Strompfad einzustellen. Der Strompfad kann mit dem elektrischen Verbraucher verbunden sein, um den elektrischen Verbraucher mit über den Strompfad abgesicherter und/oder begrenzter elektrischer Leistung zu versorgen.

In einer Ausführungsform weist das steuerbare Leistungsschutzelement einen steuerbaren Leistungsschutzschalter auf, welcher in dem Strompfad angeordnet ist, wobei der steuerbare Leistungsschutzschalter ausgebildet ist, den ersten Stromstärkegrenzwert oder den zweiten Stromstärkegrenzwert einzustellen. Der steuerbare Leistungsschutzschalter kann eine Sicherung respektive Überstromschutzeinrichtung sein, welche insbesondere für Niederspannungsnetze nutzbar sein kann. Insbesondere kann der Leistungsschutzschalter ein wiederverwendbares und/oder nicht selbsttätig rückstellendes Sicherungselement sein. Ferner kann der steuerbare Leistungsstromschalter mit einem Fehlerstromschutzschalter kombiniert sein, wobei der Fehlerstromschutzschalter einen Stromfluss zu einem Erdungspotential der Energieversorgungsvorrichtung unterbinden oder begrenzen kann. Die Überstromeinrichtung kann ferner eine zerstörbare Schmelzsicherung sein.

In einer Ausführungsform weist das steuerbare Leistungsschutzelement einen ersten Strompfad mit dem ersten Stromstärkegrenzwert und einen zweiten Strompfad mit dem zweiten Stromstärkegrenzwert auf, wobei das steuerbare Leistungsschutzelement ausgebildet ist, zur Einstellung des ersten Stromstärkegrenzwertes den zweiten Strompfad zu unterbrechen und/oder zur Einstellung des zweiten Stromstärkegrenzwertes den ersten Strompfad zu unterbrechen. Dadurch wird der Vorteil erreicht, dass das steuerbare Leistungsschutzelement mittels eines elektronischen oder mechanischen Schalters den ersten Stromstärkegrenzwert oder den zweiten Stromstärkegrenzwert einstellen kann indem der Schalter den ersten Strompfad oder den zweiten Strompfad mit der Stromversorgungseinrichtung verbindet. Insbesondere kann diese Einstellung ohne eine weitere Steuerlogik, Prozessor und/oder elektronische Leistungsbauteile realisiert sein, sodass die Herstellungskosten für die Energieversorgungsvorrichtung vorteilhaft reduziert sein können. In jedem Strompfad kann ein Schaltelement angeordnet sein oder ein Schaltelement kann von den ersten Strompfad in den zweiten Strompfad umschalten und umgekehrt.

In einer Ausführungsform weist das steuerbare Leistungsschutzelement in dem ersten Strompfad einen ersten Leistungsschutzschalter mit dem ersten Stromstärkegrenzwert und in dem zweiten Strompfad einen zweiten Leistungsschutzschalter mit dem zweiten Stromstärkegrenzwert auf. Dadurch wird der Vorteil erreicht, dass das steuerbare Leistungsschutzelement effizient zwischen dem ersten Stromstärkegrenzwert und dem zweiten Stromstärkegrenzwert umschalten kann. Ferner kann eine Anpassung des jeweiligen Stromstärkegrenzwertes in dem jeweils nicht aktiven Strompfad realisiert werden ohne dem Stromfluss in dem jeweils aktiven Strompfad zu beeinflussen. Ein Umschalten zu dem jeweils anderen Stromstärkegrenzwert kann beispielsweise von dem Umschalten zwischen den Strompfaden abhängig sein, insbesondere kann die Einstellung der Stromstärkegrenzwerte von dem tatsächlichen Stromfluss entkoppelt sein.

In einer Ausführungsform ist die Stromversorgungseinrichtung ausgebildet, einen Boost-Modus des elektrischen Verbrauchers zu detektieren, in welchem der elektrische Verbraucher innerhalb des Zeitintervalls den erhöhten Leistungsbedarf hat. Dadurch wird der Vorteil erreicht, dass der elektrische Verbraucher, insbesondere kurzfristig eine erhöhte Energiemenge aufnehmen kann, um beispielsweise einen Anlaufwiderstand eines elektrischen Motors oder eines elektrischen Generators zu überwinden. Ferner können auch kurzzeitige Lastspitzen eines beliebigen elektrischen Verbrauchers innerhalb des Zeitintervalls durch die Stromversorgungseinrichtung versorgt werden.

Die Detektion des Boost-Modus kann ferner genutzt werden, um bei einem Überstrom, insbesondere einem Kurzschluss die von der Stromversorgungseinrichtung gelieferte elektrische Spannung aufrechtzuerhalten. Dadurch kann der Vorteil erreicht werden, dass insbesondere magnetisch aktivierte Kurzschlusssicherungen zuverlässig auslösen.

In einer Ausführungsform ist das steuerbare Leistungsschutzelement ausgebildet, den elektrischen Strom mit einer Stromstärke, welche einem Vielfachen der Stromstärke des elektrischen Stroms außerhalb des Boost-Modus, insbesondere einem 1,5-fachen, 2-fachen, 5-fachen oder 10-fachen entspricht, zu leiten.

In einer Ausführungsform ist weist die Stromversorgungseinrichtung einen Leistungsmonitor auf, welcher ausgebildet ist, den Leistungsbedarf zu überwachen, um den erhöhten Leistungsbedarf zu erfassen. Dadurch wird der Vorteil erreicht dass die Stromversorgungseinrichtung das steuerbare Leistungsschutzelement effizienter ansteuern kann, um von dem ersten Stromstärkegrenzwert zu dem zweiten Stromstärkegrenzwert oder umgekehrt wechseln zu können. Die Stromversorgungseinrichtung kann mittels des Leistungsmonitors Erfassen, ob eine Stromstärke des elektrischen Stroms unterhalb des ersten Stromstärkegrenzwertes liegt und entsprechend das steuerbare Leistungsschutzelement ansteuern, um von dem zweiten Stromstärkegrenzwert zu dem ersten Stromstärkegrenzwert zu wechseln, falls der zweite Stromstärkegrenzwert eingestellt ist. Der Leistungsmonitor kann ferner ausgebildet sein, eine elektrische Leistung oder eine elektrische Energiemenge zu erfassen.

Der Leistungsmonitor kann ausgebildet sein den Leistungsmesswert mit einer vorbestimmten Frequenz zu aktualisieren, wobei vorteilhafterweise die Summe aus Aktualisierungsperiode und Schaltzeit von dem ersten Stromstärkegrenzwert zu dem zweiten Stromstärkegrenzwert kleiner sein kann, als die Aktivierungszeit des steuerbaren Leistungsschutzelements. Die Aktivierungszeit beschreibt eine Zeitverzögerung zwischen dem Fließen eines elektrischen Stroms mit einer Stromstärke oberhalb des ersten Stromstärkegrenzwertes oder des zweiten Stromstärkegrenzwertes. Dadurch kann vorteilhafterweise ein Umschalten von dem ersten Stromstärkegrenzwert zu dem zweiten Stromstärkegrenzwert realisiert werden, bevor das steuerbare Leistungsschutzelement den Stromfluss zu dem elektrischen Verbraucher unterbricht.

In einer Ausführungsform weist die Stromversorgungseinrichtung einen Steuerausgang zur Ausgabe eines Steuersignals zur Einstellung des jeweiligen Stromstärkegrenzwertes durch das steuerbare Leistungsschutzelement auf, wobei das steuerbare Leistungsschutzelement einen Steuereingang aufweist, und wobei der Steuerausgang mit dem Steuereingang verbunden ist, und wobei das steuerbare Leistungsschutzelement ausgebildet ist, den jeweiligen Stromstärkegrenzwert ansprechend auf den Empfang des Steuersignals an dem Steuereingang einzustellen. Dadurch wird der Vorteil erreicht, dass das Steuersignal effizient von der Stromversorgungseinrichtung zu dem steuerbaren Leistungsschutzelement geleitet werden kann, um zwischen dem ersten Stromstärkegrenzwert und dem zweiten Stromstärkegrenzwert und umgekehrt umzuschalten. Der Steuereingang und der Steuerausgang können drahtlos oder galvanisch getrennt miteinander verbunden sein, um eine potentialfreie elektrische Verbindung zwischen dem Steuereingang und dem Steuerausgang zu realisieren.

In einer Ausführungsform ist die Stromversorgungseinrichtung ausgebildet, das Zeitintervall anzupassen, um die Zeitdauer in welcher durch das steuerbare Leistungsschutzelement der zweite Stromstärkegrenzwert eingestellt ist, anzupassen. Dadurch wird der Vorteil erreicht, dass die Energieversorgungsvorrichtung an elektrische Verbraucher mit unterschiedlichen Anforderungen an eine zeitlich begrenzte erhöhte Leistungsaufnahme anpassbar sein kann.

In einer Ausführungsform ist die Stromversorgungseinrichtung ausgebildet, das Zeitintervall, insbesondere in einem Bereich von 0 s bis 10 s anzupassen. Das Zeitintervall kann durch Parameter des elektrischen Verbrauchers bestimmt sein. Eine Leistungszufuhr zu dem elektrischen Verbraucher oberhalb der in dem ersten Betriebsmodus vorbestimmten Grenzwerte kann eine zusätzliche Belastung des elektrischen Verbrauchers und/oder der Stromversorgungseinrichtung erzeugen, welche beispielsweise nur für ein begrenztes Zeitintervall zulässig sein kann.

Insbesondere kann eine Stromstärke oberhalb des ersten Stromstärkegrenzwertes einen zusätzlichen Wärmeeintrag in der Stromversorgungseinrichtung und/oder dem elektrischen Verbraucher erzeugen, welcher zusätzlich die Wärmeabfuhrkapazitäten der Stromversorgungseinrichtung und/oder des elektrischen Verbrauchers übersteigen kann. Eine Beschränkung der erhöhten Stromstärke auf ein vorbestimmtes Zeitintervall realisiert den Vorteil, dass die Stromversorgungseinrichtung und/oder der elektrische Verbraucher nach Ablauf des Zeitintervalls in einen thermischen und/oder elektrischen Gleichgewichtszustand zurückkehren können.

Weiterhin kann die Stromversorgungseinrichtung, das steuerbare Leistungsschutzelement und/oder die Stromversorgungsleitung jeweils einen ohmschen Widerstand aufweisen, sodass eine elektrische Verlustleistung auftreten kann, welche in Wärme umgesetzt wird und die Temperatur der Energieversorgungsvorrichtung erhöhen kann, falls der Wärmeeintrag größer ist als eine an die Umgebung der Energieversorgungsvorrichtung abgegebene Wärmemenge. Dies kann insbesondere bei eingestelltem zweitem Stromstärkegrenzwert möglich sein. Die elektrische Verlustleistung kann proportional zu der Stromstärke des durch die Energieversorgungsvorrichtung fließenden elektrischen Stroms sein, sodass die Temperatur der Energieversorgungsvorrichtung als Maß für die Stromstärke des elektrischen Stroms genutzt werden kann.

In einer Ausführungsform weist die Stromversorgungseinrichtung ein Netzteil auf, welches ausgebildet ist, elektrische Leistung von einem Stromversorgungsnetz aufzunehmen und dem elektrischen Verbraucher bereitzustellen. Das Netzteil kann ausgebildet sein eine von einem Energieversorgungsnetz bereitgestellte Spannung in eine für den elektrischen Verbraucher zulässige elektrische Spannung zu transformieren. Insbesondere das Netzteil ausgebildet sein, die Spannung zu erhöhen, zu verringern und/oder gleichzurichten. Das Netzteil kann einen festeingestellten oder variablen maximalen Ausgangsstrom aufweisen und/oder eine festeingestellte oder variable Ausgangsspannung aufweisen. Weiterhin kann das Netzteil ein Schaltnetzteil ein geregeltes Trafonetzteil oder ein ungeregeltes Trafonetzteil sein.

In einer Ausführungsform ist das steuerbare Leistungsschutzelement ausgebildet, die Stromstärke des elektrischen Stroms bei Erreichen des ersten Stromstärkegrenzwertes und/oder bei Erreichen des zweiten Stromstärkegrenzwertes zu begrenzen. Dadurch wird der Vorteil erreicht, dass der Stromfluss zu dem elektrischen Verbraucher nicht unterbunden sein kann, sondern stattdessen mit einer reduzierten Stromstärke und/oder einer reduzierten Spannung fortgesetzt werden kann, um eine unterbrechungsfreie Stromversorgung des elektrischen Verbrauchers zu gewährleisten. Weiterhin kann durch eine Begrenzung des elektrischen Stroms der elektrische Verbraucher vor einem Überstrom, insbesondere einem Kurzschlussstrom geschützt sein.

Gemäß einem zweiten Aspekt betrifft die Offenbarung ein Verfahren zur überstromgesicherten Versorgung eines elektrischen Verbrauchers mit elektrischer Leistung, mit Bereitstellen eines elektrischen Stroms für den elektrischen Verbraucher durch eine Stromversorgungseinrichtung, Unterbinden der Zufuhr des elektrischen Stromes zu dem elektrischen Verbraucher durch ein steuerbares Leistungsschutzelement bei Erreichen eines ersten Stromstärkegrenzwertes durch den elektrischen Strom, wobei das steuerbare Leistungsschutzelement ferner einen durch die Stromversorgungseinrichtung einstellbaren zweiten Stromstärkegrenzwert aufweist, wobei der zweite Stromstärkegrenzwert höher als der erste Stromstärkegrenzwert ist, Ansteuern des steuerbaren Leistungsschutzelementes durch die Stromversorgungseinrichtung zur Einstellung des zweiten Stromstärkegrenzwertes bis zum Ablauf eines Zeitintervalls bei Erfassen eines höheren Leistungsbedarfs des elektrischen Verbrauchers in dem Zeitintervall durch die Stromversorgungseinrichtung, und Unterbinden der Stromzufuhr zu dem elektrischen Verbraucher bei Erreichen des zweiten Stromgrenzwertes innerhalb des Zeitintervalls durch das steuerbare Leistungsschutzelement, wobei das Verfahren ein Detektieren des erhöhten Leistungsbedarfs bei einer steigenden Stromamplitude des elektrischen Stroms mittels der Stromversorgungseinrichtung umfasst, falls eine Amplitudensteigung einen vorbestimmten Steigungsgrenzwert nicht überschreitet.

In einer Ausführungsform ist die Stromversorgungseinrichtung ausgebildet, den ersten Stromstärkegrenzwert und/oder den zweiten Stromstärkegrenzwert anzupassen. Dadurch wird der Vorteil erreicht, dass die Stromversorgungseinrichtung an die Vorgaben unterschiedlicher elektrischer Verbraucher anpassbar sein kann und die Energieversorgungsvorrichtung ohne Änderungen der Hardware oder anderer Geräteeigenschaften der Energieversorgungsvorrichtung für die Stromversorgung von unterschiedlichen elektrischen Verbrauchern verwendet werden kann. Ferner können die Stromstärkegrenzwerte während des Betriebs der Energieversorgungsvorrichtung angepasst werden, um beispielsweise einem veränderlichen elektrischen Energiebedarf des elektrischen Verbrauchers zu folgen und/oder zu jedem Zeitpunkt bei einer unerwarteten Abweichung das steuerbare Leistungsschutzelement auslösen zu können.

In einer Ausführungsform weist die Energieversorgungsvorrichtung eine Konfigurationsschnittstelle auf, welche ausgebildet ist, eine Benutzereingabe entgegenzunehmen und an die Stromversorgungseinrichtung zu leiten, wobei die Stromversorgungseinrichtung ausgebildet ist, anhand der Benutzereingabe das steuerbare Leistungsschutzelement zu steuern, um den ersten Stromstärkegrenzwert und/oder den zweiten Stromstärkegrenzwert, insbesondere in einem Bereich von 0 A bis 30 A anzupassen. Dadurch wird der Vorteil erreicht, dass die Energieversorgungsvorrichtung effizient konfigurierbar sein kann und an benutzerdefinierte Spezifikationen angepasst werden kann. Die Konfigurationsschnittstelle kann ein haptisches Bedienelement sein, welches beispielsweise Tasten und/oder ein druck- bzw. berührungsempfindliches Feld aufweist, um manuelle Eingaben des Benutzers entgegen zu nehmen. Die Benutzereingabe kann durch ein Bestätigungssignal bestätigt werden, wobei das Bestätigungssignal elektronisch, akustisch und/oder optisch realisiert sein kann.

Die Konfigurationsschnittstelle kann eine elektronische Konfigurationsschnittstelle sein, welche über eine Kommunikationsverbindung mit einem, insbesondere entfernt von der Energieversorgungsvorrichtung angeordnetem Konfigurationsgerät verbunden sein kann. Dadurch kann die Energieversorgungsvorrichtung unabhängig von einem Einsatzort der Energieversorgungsvorrichtung konfigurierbar sein. Die Kommunikationsschnittstelle kann ausgebildet sein, drahtlos oder drahtgebunden mit dem Konfigurationsgerät zu kommunizieren.

In einer Ausführungsform weist das steuerbare Leistungsschutzelement einen dritten Strompfad auf, welcher ausgebildet ist, zumindest einen Teil des elektrischen Stroms von der elektrischen Energiequelle zu einem weiteren elektrischen Verbraucher zu leiten, wobei das steuerbare Leistungsschutzelement ausgebildet ist, bei Erreichen des ersten Stromstärkegrenzwertes oder des zweiten Stromstärkegrenzwertes durch die Summe der Stromstärke des durch den ersten Strompfad respektive den zweiten Strompfad und der Stromstärke des durch den dritten Strompfad fließenden elektrischen Stroms ein Fließen des elektrischen Stroms zu unterbinden. Dadurch wird der Vorteil erreicht, dass die Energieversorgungsvorrichtung zur Energieversorgung zumindest eines weiteren elektrischen Verbrauchers genutzt werden kann. Die Stromstärken des jeweils zu den elektrischen Verbrauchern fließenden elektrischen Stroms können durch die Stromversorgungseinrichtung in Summe überwacht werden, sodass der von der Energieversorgungsvorrichtung zu den zwei elektrischen Verbrauchern gelieferte elektrische Strom, eine vorbestimmte Stromstärke nicht übersteigt. Der dritte Strompfad kann in zwei Teilstrompfade geteilt sein, welche jeweils einen Leistungsschutzschalter aufweisen, wobei ein Teilstrompfad den ersten Stromstärkegrenzwert einstellt und ein weiterer Teilstrompfad den zweiten Stromstärkegrenzwert einstellt.

Die Energieversorgungsvorrichtung kann für die Abgabe einer bestimmten elektrischen Leistung spezifiziert sein, welche sich aus der Summe der an die

Energieversorgungsvorrichtung angeschlossenen elektrischen Verbraucher zusammensetzen kann. Ein Auslösen des steuerbaren Leistungsschutzelements bei Erreichen des ersten Stromstärkegrenzwertes oder des zweiten Stromstärkegrenzwertes durch die Summe der zu den elektrischen Verbrauchern fließenden elektrischen Ströme kann die Energieversorgungsvorrichtung vor Überlastung schützen.

In einer Ausführungsform weist das steuerbare Leistungsschutzelement eine dritten Strompfad auf, welcher ausgebildet ist, zumindest einen Teil des elektrischen Stroms von der elektrischen Energiequelle zu einem weiteren elektrischen Verbraucher zu leiten, wobei das steuerbare Leistungsschutzelement ausgebildet ist, bei Erreichen des ersten Stromstärkegrenzwertes oder des zweiten Stromstärkegrenzwertes durch die Stromstärke des durch den ersten Strompfad respektive den zweiten Strompfad oder durch die Stromstärke des durch den dritten Strompfad fließenden elektrischen Stroms ein Fließen des elektrischen Stroms durch den ersten Strompfad respektive den zweiten Strompfad und/oder den dritten Strompfad zu unterbinden. Dadurch wird der Vorteil erreicht, das beide an die Energieversorgungsvorrichtung angeschlossenen elektrischen Verbraucher unabhängig voneinander, insbesondere in Bezug auf einen Überstrom überwacht werden können und gegebenenfalls die Stromversorgung zu dem jeweiligen elektrischen Verbraucher unterbunden sein kann.

Das steuerbare Leistungsschutzelement kann ausgebildet sein, die Stromversorgung des elektrischen Verbrauchers zu unterbinden und die Stromversorgung des weiteren elektrischen Verbrauchers aufrechtzuerhalten. Weiterhin kann das steuerbare Leistungsschutzelement für jeden elektrischen Verbraucher einen separaten ersten Stromstärkegrenzwert und zweiten Stromstärkegrenzwert aufweisen, um elektrische Verbraucher mit unterschiedlichen Anforderungen an die Energieversorgungsvorrichtung anschließen und mit elektrischer Energie versorgen zu können.

Neben der Absicherung des ersten Strompfades respektive des zweiten Strompfades und des dritten Strompfades, jeweils mit dem ersten Stromstärkegrenzwert und dem zweiten Stromstärkegrenzwert, kann das steuerbare Leistungsschutzelement zusätzlich einen Gesamtstromstärkegrenzwert aufweisen, sodass das steuerbare Leistungsschutzelement die Stromversorgung der elektrischen Verbraucher unterbindet, falls der Gesamtstromstärkegrenzwert durch die Summe der zu den elektrischen Verbrauchern fließenden elektrischen Ströme erreicht wird.

In einer Ausführungsform ist die Stromversorgungseinrichtung ausgebildet, bei Unterschreiten des zweiten Stromstärkegrenzwertes durch den elektrischen Strom das steuerbare Leistungsschutzelement anzusteuern, um den ersten Stromstärkegrenzwert einzustellen. Dadurch wird der Vorteil erreicht, dass vor Ablauf der maximal möglichen Zeit, in welcher der zweite Stromstärkegrenzwert eingestellt sein kann, zur Einstellung des ersten Stromstärkegrenzwertes zurückgekehrt werden kann. Dies kann beispielsweise die Effizienz der Energieversorgungsvorrichtung steigern.

Weitere Ausführungsformen werden bezugnehmend auf die beiliegenden Figuren erläutert. Es zeigen:
- Fig. 1: eine Energieversorgungsvorrichtung in einer Ausführungsform; und
- Fig. 2: eine Energieversorgungsvorrichtung in einer Ausführungsform.

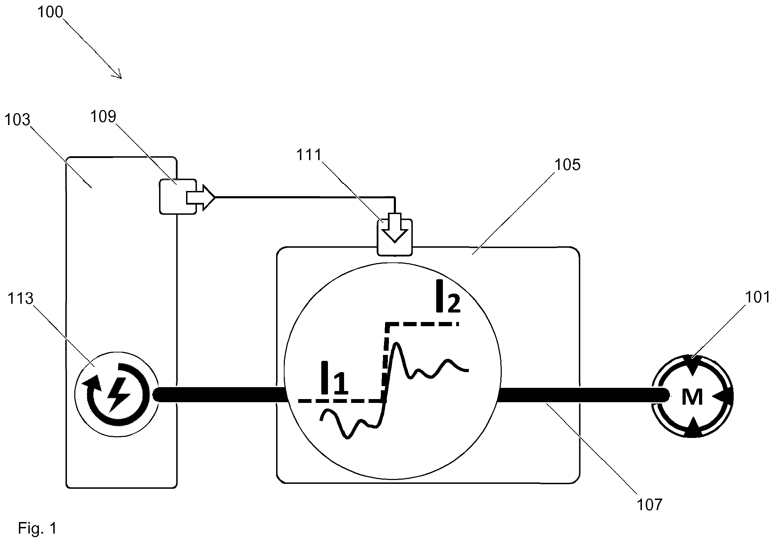

Fig. 1 zeigt eine schematische Darstellung der Energieversorgungsvorrichtung 100 zur überstromgesicherten Versorgung eines elektrischen Verbrauchers 101 mit elektrischer Leistung. Die Energieversorgungsvorrichtung 100 umfasst eine Stromversorgungseinrichtung 103, welche ausgebildet ist, einen elektrischen Strom für den elektrischen Verbraucher 101 bereitzustellen, und ein steuerbares Leistungsschutzelement 105, welches ausgebildet ist, die Zufuhr des elektrischen Stromes zu dem elektrischen Verbraucher 101 bei Erreichen eines ersten Stromstärkegrenzwertes durch den elektrischen Strom zu unterbinden. Das steuerbare Leistungsschutzelement 105 weist ferner einen durch die Stromversorgungseinrichtung 103 einstellbaren zweiten Stromstärkegrenzwert auf, wobei der zweite Stromstärkegrenzwert höher als der erste Stromstärkegrenzwert ist.

Die Stromversorgungseinrichtung 103 ist ferner ausgebildet, einen erhöhten Leistungsbedarf des elektrischen Verbrauchers 101 in einem Zeitintervall zu erfassen, und ansprechend auf das Erfassen des erhöhten Leistungsbedarfs das steuerbare Leistungsschutzelement 105 für die Dauer des Zeitintervalls (d.h. bis zum Ablauf des Zeitintervalls) zur Einstellung des zweiten Stromstärkegrenzwertes anzusteuern. Das steuerbare Leistungsschutzelement 105 ist ausgebildet, bei eingestelltem zweitem Stromstärkegrenzwert die Zufuhr des elektrischen Stromes zu dem elektrischen Verbraucher 101 bei Erreichen des zweiten Stromstärkegrenzwertes durch den elektrischen Strom zu unterbinden.

Die Stromversorgungseinrichtung 103 ist weiterhin ausgebildet, das steuerbare Leistungsschutzelement 105 nach Ablauf des Zeitintervalls zur Einstellung des ersten Stromstärkegrenzwertes anzusteuern und das steuerbare Leistungsschutzelement 105 ist ausgebildet, bei eingestelltem ersten Stromstärkegrenzwert die Zufuhr des elektrischen Stromes zu dem elektrischen Verbraucher 101 bei Erreichen des ersten Stromstärkegrenzwertes durch den elektrischen Strom zu unterbinden. Das Einstellen des ersten Stromstärkegrenzwertes oder des zweiten Stromstärkegrenzwertes kann durch die Stromversorgungseinrichtung 103 erfolgen, falls die Stromversorgungseinrichtung 103 den höheren Leistungsbedarf des elektrischen Verbrauchers 101 mittels einer steigenden Stromamplitude und/oder einer vorbestimmten Amplitudensteigung des elektrischen Stroms detektiert.

Das steuerbare Leistungsschutzelement 105 weist einen Strompfad 107 auf, welcher durch den elektrischen Strom durchsetzbar ist, und wobei das steuerbare Leistungsschutzelement (105) ausgebildet ist, den ersten Stromstärkegrenzwert oder den zweiten Stromstärkegrenzwert in dem Strompfad (107) einzustellen.

Weiterhin ist die Stromversorgungseinrichtung 103 ausgebildet, das Zeitintervall anzupassen, um die Zeitdauer in welcher durch das steuerbare Leistungsschutzelement 105 der zweite Stromstärkegrenzwert eingestellt ist, anzupassen.

Die Stromversorgungseinrichtung 103 weist ferner einen Steuerausgang 109 zur Ausgabe eines Steuersignals zur Einstellung des jeweiligen Stromstärkegrenzwertes durch das steuerbare Leistungsschutzelement 105 auf und das steuerbare Leistungsschutzelement 105 weist einen Steuereingang 111 auf, welcher mit dem Steuerausgang 109 verbunden ist. Das steuerbare Leistungsschutzelement 105 ist ferner ausgebildet, den jeweiligen Stromstärkegrenzwert ansprechend auf den Empfang des Steuersignals an dem Steuereingang 111 einzustellen. Zusätzlich weist die Stromversorgungseinrichtung 103 ein Netzteil 113 auf, welches ausgebildet ist, elektrische Leistung von einem Stromversorgungsnetz aufzunehmen und dem elektrischen Verbraucher 101 bereitzustellen.

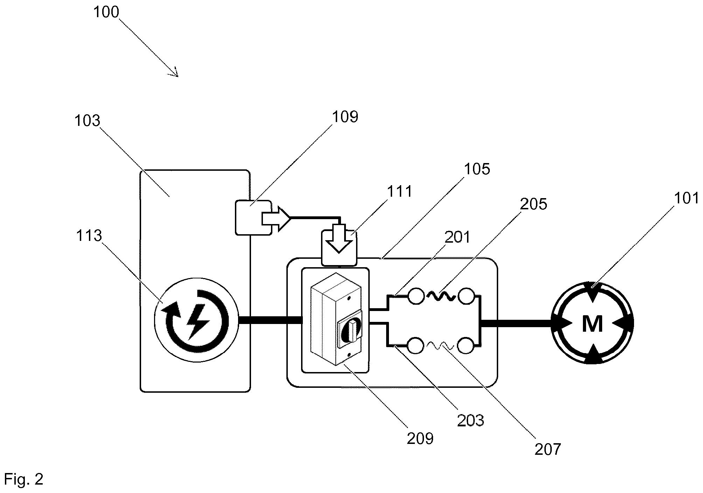

Fig. 2 zeigt eine schematische Darstellung der Energieversorgungsvorrichtung 100 zur überstromgesicherten Versorgung eines elektrischen Verbrauchers 101 mit elektrischer Leistung. Die Energieversorgungsvorrichtung 100 umfasst eine Stromversorgungseinrichtung 103, welche ausgebildet ist, einen elektrischen Strom für den elektrischen Verbraucher 101 bereitzustellen, und ein steuerbares Leistungsschutzelement 105, welches ausgebildet ist, die Zufuhr des elektrischen Stromes zu dem elektrischen Verbraucher 101 bei Erreichen eines ersten Stromstärkegrenzwertes durch den elektrischen Strom zu unterbinden. Das steuerbare Leistungsschutzelement 105 weist ferner einen durch die Stromversorgungseinrichtung 103 einstellbaren zweiten Stromstärkegrenzwert auf, wobei der zweite Stromstärkegrenzwert höher als der erste Stromstärkegrenzwert ist.

Die Stromversorgungseinrichtung 103 ist ferner ausgebildet, einen erhöhten Leistungsbedarf des elektrischen Verbrauchers 101 in einem Zeitintervall zu erfassen, und ansprechend auf das Erfassen des erhöhten Leistungsbedarfs das steuerbare Leistungsschutzelement 105 für die Dauer des Zeitintervalls (d.h. bis zum Ablauf des Zeitintervalls) zur Einstellung des zweiten

Stromstärkegrenzwertes anzusteuern. Das steuerbare Leistungsschutzelement 105 ist ausgebildet, bei eingestelltem zweitem Stromstärkegrenzwert die Zufuhr des elektrischen Stromes zu dem elektrischen Verbraucher 101 bei Erreichen des zweiten Stromstärkegrenzwertes durch den elektrischen Strom zu unterbinden.

Das steuerbare Leistungsschutzelement 105 weist einen ersten Strompfad 201 mit dem ersten Stromstärkegrenzwert und einen zweiten Strompfad 203 mit dem zweiten Stromstärkegrenzwert auf und ist ausgebildet, zur Einstellung des ersten Stromstärkegrenzwertes den zweiten Strompfad 203 zu unterbrechen und/oder zur Einstellung des zweiten Stromstärkegrenzwertes den ersten Strompfad 201 zu unterbrechen. Das steuerbare Leistungsschutzelement 105 weist in dem ersten Strompfad 201 einen ersten Leistungsschutzschalter 205 mit dem ersten Stromstärkegrenzwert und in dem zweiten Strompfad 203 einen zweiten Leistungsschutzschalter 207 mit dem zweiten Stromstärkegrenzwert auf. Die Stromversorgungseinrichtung 103 ist ausgebildet, einen Boost-Modus des elektrischen Verbrauchers 101 zu detektieren, in welchem der elektrische Verbraucher innerhalb des Zeitintervalls den erhöhten Leistungsbedarf hat. Insbesondere kann die Stromversorgung einen Leistungsmonitor aufweisen, welcher ausgebildet ist, den Leistungsbedarf zu überwachen, um den erhöhten Leistungsbedarf zu erfassen.

Das steuerbare Leistungsschutzelement 105 weist ferner einen Schalter 209 auf, welcher insbesondere ein elektronischer oder mechanischer Schalter sein kann. Der Schalter 209 ist ausgebildet, in einer ersten Schalterstellung den ersten Strompfad 201 mit der Stromversorgungseinrichtung 103 zu verbinden, um den ersten Stromstärkegrenzwert einzustellen und in einer zweiten Schalterstellung den zweiten Strompfad 203 mit der Stromversorgungseinrichtung 103 zu verbinden, um den zweiten Stromstärkegrenzwert einzustellen.

### Bezugszeichenliste

- 100: Energieversorgungsvorrichtung
- 101: Elektrischer Verbraucher
- 103: Stromversorgungseinrichtung
- 105: Steuerbares Leistungsschutzelement
- 107: Strompfad
- 109: Steuerausgang
- 111: Steuereingang
- 113: Netzteil
- 201: Erster Strompfad
- 203: Zweiter Strompfad
- 205: Erster Leistungsschutzschalter
- 207: Zweiter Leistungsschutzschalter
- 209: Schalter

## Patentansprüche

1. Energieversorgungsvorrichtung (100) zur überstromgesicherten Versorgung eines elektrischen Verbrauchers (101) mit elektrischer Leistung, mit:
einer Stromversorgungseinrichtung (103), welche ausgebildet ist, einen elektrischen Strom für den elektrischen Verbraucher (101) bereitzustellen; und
einem steuerbaren Leistungsschutzelement (105), welches ausgebildet ist, die Zufuhr des elektrischen Stromes zu dem elektrischen Verbraucher (101) bei Erreichen eines ersten Stromstärkegrenzwertes durch den elektrischen Strom zu unterbinden, wobei das steuerbare Leistungsschutzelement (105) ferner einen durch die Stromversorgungseinrichtung (103) einstellbaren zweiten Stromstärkegrenzwert aufweist,
wobei der zweite Stromstärkegrenzwert höher als der erste Stromstärkegrenzwert ist,
wobei
die Stromversorgungseinrichtung (103) ferner ausgebildet ist, einen erhöhten Leistungsbedarf des elektrischen Verbrauchers (101) in einem Zeitintervall zu erfassen,
und ansprechend auf das Erfassen des erhöhten Leistungsbedarfs das steuerbare Leistungsschutzelement (105) bis zum Ablauf des Zeitintervalls zur Einstellung des zweiten
Stromstärkegrenzwertes anzusteuern, und wobei das steuerbare Leistungsschutzelement (105) ausgebildet ist, bei eingestelltem zweiten Stromstärkegrenzwert die Zufuhr des elektrischen Stromes zu dem elektrischen Verbraucher (101) bei Erreichen des zweiten Stromstärkegrenzwertes durch den elektrischen Strom zu unterbinden,
J **dadurch**
**gekennzeichnet, dass** die Stromversorgungseinrichtung (103) ausgebildet ist, den erhöhten Leistungsbedarf bei einer steigenden Stromamplitude des elektrischen Stroms zu detektieren, falls eine Amplitudensteigung einen vorbestimmten Steigungsgrenzwert nicht überschreitet.

2. Energieversorgungsvorrichtung (100) nach Anspruch 1, wobei die Stromversorgungseinrichtung (103) ausgebildet ist, das steuerbare Leistungsschutzelement (105) nach Ablauf des Zeitintervalls zur Einstellung des ersten Stromstärkegrenzwertes anzusteuern, und wobei das steuerbare Leistungsschutzelement (105) ausgebildet ist, bei eingestelltem ersten Stromstärkegrenzwert die Zufuhr des elektrischen Stromes zu dem elektrischen Verbraucher (101) bei Erreichen des ersten Stromstärkegrenzwertes durch den elektrischen Strom zu unterbinden.

3. Energieversorgungsvorrichtung (100) nach einem der vorstehenden Ansprüche, wobei das steuerbare Leistungsschutzelement (105) einen Strompfad (107) aufweist, welcher durch den elektrischen Strom durchsetzbar ist, und wobei das steuerbare Leistungsschutzelement (105) ausgebildet ist, den ersten Stromstärkegrenzwert oder den zweiten Stromstärkegrenzwert in dem Strompfad (107) einzustellen.

4. Energieversorgungsvorrichtung (100) nach Anspruch 3, wobei das steuerbare Leistungsschutzelement (105) einen steuerbaren Leistungsschutzschalter aufweist, welcher in dem Strompfad angeordnet ist, wobei der steuerbare Leistungsschutzschalter ausgebildet ist, den ersten Stromstärkegrenzwert oder den zweiten Stromstärkegrenzwert einzustellen.

5. Energieversorgungsvorrichtung (100) nach einem der vorstehenden Ansprüche, wobei das steuerbare Leistungsschutzelement (105) einen ersten Strompfad (201) mit einem ersten Leistungsschutzschalter assoziiert mit dem ersten Stromstärkegrenzwert und einen zweiten Strompfad (203) mit einem zweiten Leistungsschutzschalter assoziiert mit dem zweiten Stromstärkegrenzwert aufweist, wobei das steuerbare Leistungsschutzelement (105) ausgebildet ist, zur Einstellung des ersten Stromstärkegrenzwertes den zweiten Strompfad (203) zu unterbrechen und/oder zur Einstellung des zweiten Stromstärkegrenzwertes den ersten Strompfad (201) zu unterbrechen.

6. Energieversorgungsvorrichtung (100) nach einem der vorstehenden Ansprüche, wobei die Stromversorgungseinrichtung (103) ausgebildet ist, einen Boost-Modus des elektrischen Verbrauchers (101) zu detektieren, in welchem der elektrische Verbraucher innerhalb des Zeitintervalls den erhöhten Leistungsbedarf hat.

7. Energieversorgungsvorrichtung (100) nach einem der vorstehenden Ansprüche, wobei die Stromversorgungseinrichtung (103) einen Leistungsmonitor aufweist, welcher ausgebildet ist, den Leistungsbedarf zu überwachen, um den erhöhten Leistungsbedarf zu erfassen.

8. Energieversorgungsvorrichtung (100) nach einem der vorstehenden Ansprüche, wobei die Stromversorgungseinrichtung (103) einen Steuerausgang (109) zur Ausgabe eines Steuersignals zur Einstellung des jeweiligen Stromstärkegrenzwertes durch das steuerbare Leistungsschutzelement (105) aufweist, wobei das steuerbare Leistungsschutzelement (105) einen Steuereingang (111) aufweist, und wobei der Steuerausgang (109) mit dem Steuereingang (111) verbunden ist, und wobei das steuerbare Leistungsschutzelement (105) ausgebildet ist, den jeweiligen Stromstärkegrenzwert ansprechend auf den Empfang des Steuersignals an dem Steuereingang (111)einzustellen.

9. Energieversorgungsvorrichtung (100) nach einem der vorstehenden Ansprüche, wobei die Stromversorgungseinrichtung (103) ausgebildet ist, das Zeitintervall anzupassen, um die Zeitdauer in welcher durch das steuerbare Leistungsschutzelement (105) der zweite Stromstärkegrenzwert eingestellt ist anzupassen.

10. Energieversorgungsvorrichtung (100) nach einem der vorstehenden Ansprüche, wobei die Stromversorgungseinrichtung (103) ein Netzteil (113) aufweist, welches ausgebildet ist, elektrische Leistung von einem Stromversorgungsnetz aufzunehmen und dem elektrischen Verbraucher (101) bereitzustellen.

11. Verfahren zur überstromgesicherten Versorgung eines elektrischen Verbrauchers (101) mit elektrischer Leistung, umfassend die Schritte:
Bereitstellen eines elektrischen Stroms für den elektrischen Verbraucher (101) durch eine Stromversorgungseinrichtung (103);
Unterbinden der Zufuhr des elektrischen Stromes zu dem elektrischen Verbraucher (101) durch ein steuerbares Leistungsschutzelement (105) bei Erreichen eines ersten Stromstärkegrenzwertes durch den elektrischen Strom, wobei das steuerbare Leistungsschutzelement (105) ferner einen durch die Stromversorgungseinrichtung (103) einstellbaren zweiten Stromstärkegrenzwert aufweist, wobei der zweite Stromstärkegrenzwert höher als der erste Stromstärkegrenzwert ist; Ansteuern des steuerbaren Leistungsschutzelementes (105) durch die Stromversorgungseinrichtung (103) zur Einstellung des zweiten Stromstärkegrenzwertes bis zum Ablauf eines Zeitintervalls bei Erfassen eines höheren Leistungsbedarfs des elektrischen Verbrauchers (101) in dem Zeitintervall durch die Stromversorgungseinrichtung (103); und Unterbinden der Stromzufuhr zu dem elektrischen Verbraucher (101) bei Erreichen des zweiten Stromstärkegrenzwertes durch das steuerbare Leistungsschutzelement (105),
J **dadurch gekennzeichnet, dass** das Verfahren ein
Detektieren des erhöhten Leistungsbedarf bei einer steigenden Stromamplitude des elektrischen Stroms mittels der Stromversorgungseinrichtung (103) umfasst, falls eine Amplitudensteigung einen vorbestimmten Steigungsgrenzwert nicht überschreitet.

## Claims

1. An energy supply apparatus (100) for overcurrent-protected supply of electrical power to an electrical consumer (101), the energy supply apparatus (100) comprising:
a power supply device (103), which is configured to provide an electric current for the electrical consumer (101); and
a controllable power protection element (105), which is configured to disable the supply of the electric current to the electrical consumer (101) when the current reaches a first current limit value, wherein the controllable power protection element (105) further comprises a second current limit value, adjustable by the power supply device (103), wherein the second current limit value is higher than the first current limit value, wherein
the power supply device (103) is further configured to detect an increased power requirement of the electrical consumer (101) within a time interval and, in response to the detection of the increased power requirement, to control the controllable power protection element (105) until the time interval expires for adjusting the second current limit value and
wherein the controllable power protection element (105) is configured, when the second current limit value is set, to disable the supply of the electric current to the electrical consumer (101) upon reaching the second current limit value by the electric current,
**characterized in that** the power supply device (103) is configured to detect the increased power requirement during an increasing current amplitude of the electric current, if an amplitude gradient does not exceed a predetermined gradient limit value.

2. The energy supply device (100) according to claim 1, wherein the power supply device (103) is configured to control the controllable power protection element (105) after expiry of the time interval for setting the first current limit value and wherein the controllable power protection element (105) is configured, when the first current limit value is set, to disable the supply of the electric current to the electrical consumer (101) when the electric current reaches the first current limit value.

3. The energy supply apparatus (100) according to one of the preceding claims, wherein the controllable power protection element (105) comprises a current path (107) which can be permeated by the electric current, and wherein the controllable power protection element (105) is configured to adjust the first current limit value or the second current limit value in the current path (107).

4. The energy supply apparatus (100) according to claim 3, wherein the controllable power protection element (105) comprises a controllable circuit breaker, which is arranged in the current path, wherein the controllable circuit breaker is configured to adjust the first current limit value or the second current limit value.

5. The energy supply apparatus (100) according to one of the preceding claims, wherein the controllable power protection element (105) comprises a first current path (201) comprising a first circuit breaker associated with the first current limit value and a second current path (203) comprising a second circuit breaker associated with the second current limit value, wherein the controllable power protection element (105) is configured to interrupt the second current path (203) for adjusting the first current limit value and/or interrupt the first current path (201) for adjusting the second current limit value.

6. The energy supply apparatus (100) according to one of the preceding claims, wherein the power supply device (103) is configured to detect a boost mode of the electrical consumer (101), in which the electrical consumer has the increased power requirement within the time interval.

7. The energy supply apparatus (100) according to one of the preceding claims, wherein the power supply device (103) comprises a power monitor that is configured to monitor the power requirement in order to detect the increased power requirement.

8. The energy supply apparatus (100) according to one of the preceding claims, wherein the power supply device (103) comprises a control output (109) for outputting a control signal for setting the respective current limit value by the controllable power protection element (105), wherein the controllable power protection element (105) comprises a control input (111) and wherein the control output (109) is connected to the control input (111) and wherein the controllable power protection element (105) is configured to adjust the respective current limit value in response to receiving the control signal at the control input (111).

9. The energy supply apparatus (100) according to one of the preceding claims, wherein the power supply device (103) is configured to adapt the time interval in order to adapt the time period in which the second current limit value is set by the controllable power protection element (105).

10. The energy supply apparatus (100) according to one of the preceding claims, wherein the power supply device (103) further comprises a power adapter (113), which is configured to take electrical power from a mains supply network and provide the electrical power for the electrical consumer (101).

11. A method for overcurrent-protected supply of electrical power to an electrical consumer (101), the method comprising the following steps:
providing an electric current for the electrical consumer (101) by a power supply device (103);
disabling the supply of the electric current to the electrical consumer (101) by a controllable power protection element (105) when the electric current reaches a first current limit value,
wherein the controllable power protection element (105) further comprises a second current limit value, adjustable by the power supply device (103), wherein the second current limit value is higher than the first current limit value;
controlling the controllable power protection element (105) by the power supply device (103) for adjusting the second current limit value until a time interval expires when detecting an increased power requirement of the electrical consumer (101) by the power supply device (103) within the time interval; and
disabling the supply of the current to the electrical consumer (101) by the controllable power protection element (105) upon reaching the second current limit value,
**characterized in that** the method comprises a detection of the increased power requirement during an increasing current amplitude of the electric current, if an amplitude gradient does not exceed a predetermined gradient limit value.

## Revendications

1. Dispositif d'alimentation en énergie (100) permettant d'alimenter un consommateur électrique (101) en puissance électrique de manière protégée contre les surintensités de courant, comprenant :
un équipement d'alimentation en courant (103) qui est réalisé pour fournir un courant électrique destiné au consommateur électrique (101) ; et
un élément de protection de puissance pouvant être commandé (105) qui est réalisé pour interdire l'arrivée du courant électrique au consommateur électrique (101) lorsque le courant électrique atteint une première valeur limite d'intensité de courant, l'élément de protection de puissance pouvant être commandé (105) présentant en outre une deuxième valeur limite d'intensité de courant réglable par l'équipement d'alimentation en courant (103), la deuxième valeur limite d'intensité de courant étant supérieure à la première valeur limite d'intensité de courant,
dans lequel
l'équipement d'alimentation en courant (103) est en outre réalisé pour détecter une demande de puissance accrue du consommateur électrique (101) dans un intervalle de temps, et en réponse à la détection de la demande de puissance accrue, pour piloter l'élément de protection de puissance pouvant être commandé (105) jusqu'à expiration de l'intervalle de temps afin de régler la deuxième valeur limite d'intensité de courant, et l'élément de protection de puissance pouvant être commandé (105) est réalisé, lorsque la deuxième valeur limite d'intensité de courant est réglée, pour interdire l'arrivée du courant électrique au consommateur électrique (101) lorsque le courant électrique atteint la deuxième valeur limite d'intensité de courant,
**caractérisé en ce que** l'équipement d'alimentation en courant (103) est réalisé pour détecter la demande de puissance accrue en cas d'amplitude de courant croissante du courant électrique si une croissance de l'amplitude ne dépasse pas une valeur limite de croissance prédéterminée.

2. Dispositif d'alimentation en énergie (100) selon la revendication 1, dans lequel l'équipement d'alimentation en courant (103) est réalisé pour piloter l'élément de protection de puissance pouvant être commandé (105) après expiration de l'intervalle de temps afin de régler la première valeur limite d'intensité de courant, et l'élément de protection de puissance pouvant être commandé (105) est réalisé, lorsque la première valeur limite d'intensité de courant est réglée, pour interdire l'arrivée du courant électrique au consommateur électrique (101) lorsque le courant électrique atteint la première valeur limite d'intensité de courant.

3. Dispositif d'alimentation en énergie (100) selon l'une quelconque des revendications précédentes, dans lequel l'élément de protection de puissance pouvant être commandé (105) présente un chemin de courant (107) par lequel le courant électrique peut passer, et l'élément de protection de puissance pouvant être commandé (105) est réalisé pour régler la première valeur limite d'intensité de courant ou la deuxième valeur limite d'intensité de courant sur le chemin de courant (107).

4. Dispositif d'alimentation en énergie (100) selon la revendication 3, dans lequel l'élément de protection de puissance pouvant être commandé (105) présente un disjoncteur de puissance pouvant être commandé qui est disposé sur le chemin de courant, le disjoncteur de puissance pouvant être commandé étant réalisé pour régler la première valeur limite d'intensité de courant ou la deuxième valeur limite d'intensité de courant.

5. Dispositif d'alimentation en énergie (100) selon l'une quelconque des revendications précédentes, dans lequel l'élément de protection de puissance pouvant être commandé (105) présente un premier chemin de courant (201) avec un premier disjoncteur de puissance associé à la première valeur limite d'intensité de courant et un deuxième chemin de courant (203) avec un deuxième disjoncteur de puissance associé à la deuxième valeur limite d'intensité de courant, dans lequel l'élément de protection de puissance pouvant être commandé (105) est réalisé pour déconnecter le deuxième chemin de courant (203) afin de régler la première valeur limite d'intensité de courant, et/ou pour déconnecter le premier chemin de courant (201) afin de régler la deuxième valeur limite d'intensité de courant.

6. Dispositif d'alimentation en énergie (100) selon l'une quelconque des revendications précédentes, dans lequel l'équipement d'alimentation en courant (103) est réalisé pour détecter un mode boost du consommateur électrique (101) dans lequel le consommateur électrique présente une demande de puissance accrue à l'intérieur de l'intervalle de temps.

7. Dispositif d'alimentation en énergie (100) selon l'une quelconque des revendications précédentes, dans lequel l'équipement d'alimentation en courant (103) présente un moniteur de puissance qui est réalisé pour surveiller la demande de puissance afin de détecter la demande de puissance accrue.

8. Dispositif d'alimentation en énergie (100) selon l'une quelconque des revendications précédentes, dans lequel l'équipement d'alimentation en courant (103) présente une sortie de commande (109) pour sortir un signal de commande permettant de régler la valeur limite d'intensité de courant respective par l'élément de protection de puissance pouvant être commandé (105), dans lequel l'élément de protection de puissance pouvant être commandé (105) présente une entrée de commande (111) et la sortie de commande (109) est reliée à l'entrée de commande (111), et dans lequel l'élément de protection de puissance pouvant être commandé (105) est réalisé pour régler la valeur limite d'intensité de courant respective en réponse à la réception du signal de commande à l'entrée de commande (111) .

9. Dispositif d'alimentation en énergie (100) selon l'une quelconque des revendications précédentes, dans lequel l'équipement d'alimentation en courant (103) est réalisé pour adapter l'intervalle de temps afin d'adapter la durée pendant laquelle l'élément de protection de puissance pouvant être commandé (105) règle la deuxième valeur limite d'intensité de courant.

10. Dispositif d'alimentation en énergie (100) selon l'une quelconque des revendications précédentes, dans lequel l'équipement d'alimentation en courant (103) présente un bloc d'alimentation (113) qui est réalisé pour recevoir une puissance électrique provenant d'un réseau d'alimentation en courant et pour la fournir au consommateur électrique (101).

11. Procédé permettant d'alimenter un consommateur électrique (101) en puissance électrique de manière protégée contre les surintensités de courant, comprenant les étapes consistant à :
fournir un courant électrique destiné au consommateur électrique (101) par un équipement d'alimentation en courant (103) ;
interdire l'arrivée du courant électrique au consommateur électrique (101) par un élément de protection de puissance pouvant être commandé (105) lorsque le courant électrique atteint une première valeur limite d'intensité de courant, dans lequel l'élément de protection de puissance pouvant être commandé (105) présente en outre une deuxième valeur limite d'intensité de courant réglable par l'équipement d'alimentation en courant (103), la deuxième valeur limite d'intensité de courant étant supérieure à la première valeur limite d'intensité de courant ;
piloter l'élément de protection de puissance pouvant être commandé (105) par l'équipement d'alimentation en courant (103) afin de régler la deuxième valeur limite d'intensité de courant jusqu'à l'expiration d'un intervalle de temps lorsque l'équipement d'alimentation en courant (103) détecte une demande de puissance accrue du consommateur électrique (101) dans l'intervalle de temps ; et
interdire l'arrivée de courant au consommateur électrique (101) lorsque l'élément de protection de puissance pouvant être commandé (105) atteint la deuxième valeur limite d'intensité de courant,
**caractérisé en ce que** le procédé comprend une détection de la demande de puissance accrue en cas d'amplitude de courant croissante du courant électrique au moyen de l'équipement d'alimentation en courant (103) si une croissance de l'amplitude ne dépasse pas une valeur limite de croissance prédéterminée.
